# EUROPEAN PATENT APPLICATION

(11) **EP 1 657 264 A1**
(43) Date of publication of application: **17.05.2006**
(21) Application number: 04771898.6
(22) Date of filing: 19.08.2004
(51) Int. Cl.: C08F 236/20, C08L 47/00, G03F 7/039, G03F 7/033

(54) **FLUOROCOPOLYMER, PROCESS FOR PRODUCING THE SAME, AND RESIST COMPOSITION CONTAINING THE SAME**

(30) Priority: 21.08.2003 JP 2003297404; 27.04.2004 JP 2004131485
(71) Applicant: ASAHI GLASS COMPANY LTD., Tokyo 100-8405 (JP)
(72) Inventor: TAKEBE, Yoko, c/o Asahi Glass Company, Limited, Yokohama-shi, Kanagawa 221-8755 (JP); EDA, Masataka, c/o Asahi Glass Company, Limited, Yokohama-shi, Kanagawa 221-8755 (JP); YOKOKOJI, Osamu, c/o Asahi Glass Company, Limited, Yokohama-shi, Kanagawa 221-8755 (JP)
(74) Representative: Müller-Boré & Partner Patentanwälte
(86) International application number: PCT/JP2004/011937
(87) International publication number: WO 2005/019284

(57) **Abstract**

To provide a fluoropolymer having functional groups and having high transparency in a wide wavelength region, and a resist composition comprising the fluoropolymer.

A fluorinated copolymer having units derived from a monomer unit formed by cyclopolymerization of a fluorinated diene represented by the following formula (1) :

CF₂=CFCH₂CH(CH₂C(CF₃)₂(OR¹)) CH₂CH=CH₂ (1)

wherein R¹ is a hydrogen atom, an alkyl group having at most 20 carbon atoms, which may have an etheric oxygen atom, an alkoxycarbonyl group having at most 6 carbon atoms, or CH₂R² (wherein R² is an alkoxycarbonyl group having at most 6 carbon atoms), and units derived from a monomer unit formed by cyclopolymerization of another monomer or units derived from a monomer unit formed by polymerization of an acrylic monomer, and a resist composition having such a fluorinated copolymer as a base polymer.

## Description

### TECHNICAL FIELD

The present invention relates to a novel fluorinated copolymer, a process for its production and a resist composition.

### BACKGROUND ART

As fluoropolymers having functional groups, functional group-containing fluoropolymers are known which are used for fluorinated ion exchange membranes, curable fluorinated resin coating materials, etc. However, they are basically straight chained polymers, and they are obtainable by copolymerization of a fluoroolefin represented by tetrafluoroethylene with a monomer having a functional group.

Further, a polymer containing functional groups and having a fluorinated alicyclic structure in its main chain, is also known. As a method for introducing functional groups to the polymer having a fluorinated alicyclic structure in its main chain, a method of utilizing terminal groups of a polymer obtained by polymerization, a method of subjecting a polymer to high temperature treatment to oxidize and decompose side chains or terminals of the polymer to form functional groups, or a method of copolymerizing a monomer having a functional group, if necessary, by adding treatment such as hydrolysis to introduce functional groups, is, for example, known (see Patent Documents 1, 2, 3 and 4).

The above-mentioned methods are available as methods for introducing functional groups to a polymer having a fluorinated alicyclic structure in its main chain. However, the method for introducing functional groups by treating the terminal groups of the polymer, has a drawback that the functional group concentration is low, and no adequate characteristics of the functional groups can be obtained. Whereas, by the method for introducing functional groups by copolymerizing a monomer having a functional group, there will be a problem such that if the functional group concentration is increased, the mechanical properties tend to decrease due to a decrease of the glass transition temperature (Tg).
Patent Document 1: JP-A-4-189880
Patent Document 2: JP-A-4-226177
Patent Document 3: JP-A-6-220232
Patent Document 4: WO02/064648

### DISCLOSURE OF THE INVENTION

### PROBLEMS THAT THE INVENTION IS TO SOLVE

The present invention provides a fluorinated copolymer having high concentration of functional groups and adequate characteristics of the functional groups and having high transparency in a wide wavelength region and a process for its production. Further, the present invention provides a resist composition which can form a chemical amplification type resist excellent particularly in transparency for far ultraviolet rays such as KrF or ArF excimer laser or vacuum ultraviolet rays such as F₂ excimer laser and dry etching characteristics, and a resist pattern excellent in sensitivity, resolution, dissolution velocity, flatness, heat resistance and the like.

### MEANS OF SOLVING THE PROBLEMS

The present invention is to solve the above problems, and provides the followings.
(1) A fluorinated copolymer (A1) having units derived from a monomer unit formed by cyclopolymerization of a fluorinated diene represented by the following formula (1) and units derived from a monomer unit formed by cyclopolymerization of a functional group-containing fluorinated diene represented by the following formula (2) (provided that the fluorinated diene represented by the formula (1) is excluded):

   CF₂=CFCH₂CH(CH₂C(CF₃)₂(OR¹))CH₂CH=CH₂ (1)

   wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms;

   CF₂=CR³-Q-CR⁴=CH₂ (1)

   wherein each of R³ and R⁴ which are independent of each other, is a hydrogen atom, a fluorine atom, an alkyl group having at most 3 carbon atoms, a fluoroalkyl group having at most 3 carbon atoms, or a cyclic aliphatic hydrocarbon group, and Q is an alkylene group, an oxyalkylene group, a fluoroalkylene group or an oxyfluoroalkylene group, having a functional group or a functional group-containing side chain group.
(2) A fluorinated copolymer (A2) having units derived from a monomer unit formed by cyclopolymerization of a fluorinated diene represented by the following formula (1) and units derived from a monomer unit formed by polymerization of an acrylic monomer represented by the following formula (3):

   CF₂=CFCH₂CH(CH₂C(CF₃)₂(OR¹))CH₂CH=CH₂ (1)

   wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms;

   CH₂=CR⁵COOR⁶ (3)

   wherein R⁵ is a hydrogen atom, a fluorine atom, an alkyl group having at most 3 carbon atoms, or a fluoroalkyl group having at most 3 carbon atoms, R⁶ is an alkyl group having at most 20 carbon atoms, and some of hydrogen atoms of the alkyl group may be substituted by fluorine atoms, alkyl groups or fluoroalkyl groups.
(3) A method for producing the above fluorinated copolymer (A1) or the above fluorinated copolymer (A2), characterized by radical copolymerizing a fluorinated diene represented by the above formula (1) and a fluorinated diene represented by the above formula (2) or an acrylic monomer represented by the above formula (3).
(4) A resist composition characterized by comprising the above fluorinated copolymer (A1) or the above fluorinated copolymer (A2), an acid-generating compound (B) which generates an acid when irradiated with light, and an organic solvent (C).

### EFFECTS OF THE INVENTION

According to the present invention, it is possible to produce a fluorinated copolymer having an alicyclic structure in its main chain and having functional groups in its side chains. The fluorinated copolymer obtained by the present invention has high chemical stability and heat resistance. Yet, functional groups are introduced in the side chains of its ring, whereby it is possible to exhibit sufficient characteristics of functional groups without bringing about a decrease of Tg, which used to be difficult to accomplish with conventional fluoropolymers. Further, such a fluorinated copolymer has high transparency in a wide wavelength region. The resist composition of the present invention can be used as a chemical amplification type resist excellent particularly in transparency for far ultraviolet rays such as KrF or ArF excimer laser or vacuum ultraviolet rays such as F² excimer laser and dry etching characteristics, and can readily form a resist pattern excellent in sensitivity, resolution, flatness, heat resistance and the like.

### BEST MODE FOR CARRYING OUT THE INVENTION

By the present invention, it is possible to obtain a fluorinated copolymer (A1) having units derived from a monomer unit formed by cyclopolymerization of a fluorinated diene represented by the after-mentioned formula (1) (hereinafter referred to as fluorinated diene (1)) and units derived from a monomer unit formed by cyclopolymerization of a functional group-containing fluorinated diene represented by the after-mentioned formula (2) (provided that the fluorinated diene represented by the formula (1) is excluded, and hereinafter referred to as fluorinated diene (2)), or a fluorinated copolymer (A2) having units derived from a monomer unit formed by cyclopolymerization of a fluorinated diene (1) and monomer units formed by polymerization of an acrylic monomer represented by the after-mentioned formula (3) (hereinafter referred to as acrylic monomer (3)):

CF₂=CFCH₂CH (CH₂C (CF₃)₂(OR¹)) CH₂CH=CH₂ (1)

wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms.

The alkyl group having at most 20 carbon atoms, which may have an etheric oxygen atom, may, for example, be an alkyl group which may be substituted by an aryl group or a cycloalkyl group, a cycloalkyl group, an alkoxymethyl group or a cyclic ether group. Here, as such a cycloalkyl group, not only a monocyclic cycloalkyl group such as a cyclohexyl group, but also a polycyclic cycloalkyl group such as a cross-linked polycycloalkyl group such as an adamantyl group or a connected polycycloalkyl group such as a bicyclohexyl group may, for example, be mentioned. Further, the alkyl group moiety of an alkoxy group in e.g. the above alkoxymethyl group may be such a cycloalkyl group as described above. Further, the above alkyl group may have an etheric oxygen atom between carbon atoms (provided that the alkoxymethyl group is one of them). Further, in the above aryl group or cycloalkyl group, a substituent such as an alkyl group or an alkoxy group may be present.

As specific examples of the alkyl group having at most 20 carbon atoms, which may have an etheric oxygen atom, the following alkoxymethyl groups may be mentioned, in addition to a methyl group, a methoxymethyl group, an ethoxymethyl group, a 2-methoxyethyl group, -CH (CH₃) OC₂H₅, -CH₂OCH₂ (tert-C₄H₉), -CH₂OCH₂CF₃, -CH₂OCF₂CF₃, -CH₂OCF₂CF₂ and a 2-tetrahydropyranyl group, but the alkyl group is not limited thereto.

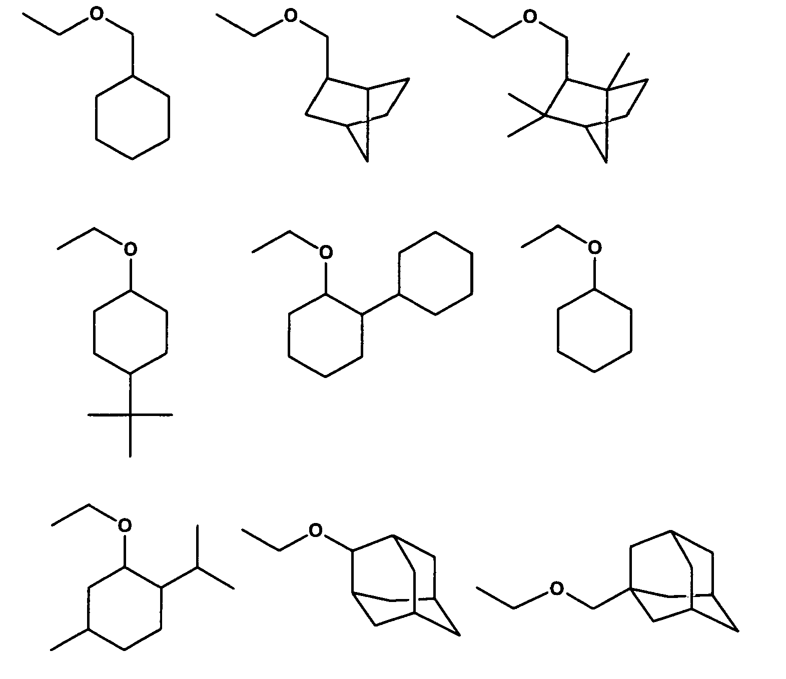

Further, it is possible to introduce the following huge one having at least 20 carbon atoms:

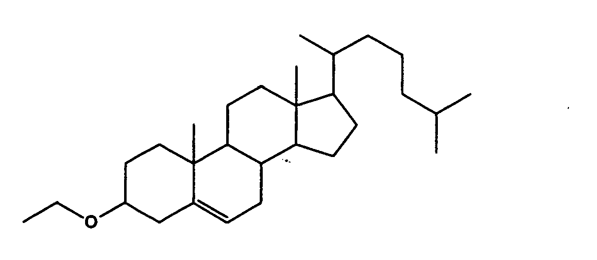

The above alkoxycarbonyl group may, for example, be a tert-butoxycarbonyl group (-COO(t-C₄H₉)) or -COO(2-AdM), and the CH₂R² may, for example, be CH₂COO(tert-C₄H₉) or CH₂COO(2-AdM). Here, 2-AdM is a 2-methyladamantyl-2-yl group. From the viewpoint of availability, R¹ is preferably a hydrogen atom, a methoxymethyl group, a t-butyl group, a tert-butoxycarbonyl group, a 2-cyclohexylcyclohexyloxymethyl group, a menthoxymethyl group or a cyclohexyloxymethyl group.

CF₂=CR³-Q-CR⁴=CH₂ (2)

Here, each of R³ and R⁴ which are independent of each other, is a hydrogen atom, a fluorine atom, an alkyl group having at most 3 carbon atoms, a fluoroalkyl group having at most 3 carbon atoms, or a cyclic aliphatic hydrocarbon group, and Q is an alkylene group, an oxyalkylene group, a fluoroalkylene group or an oxyfluoroalkylene group, having a functional group or a functional group-containing side chain group. Especially, it is preferred that R³ is a fluorine atom and R⁴ is a hydrogen atom.

Q is an organic group having a functional group or a functional group-containing side chain. In the present invention, the functional group is meant for a group which provides a desired function, and it may, for example, be an ion exchange group, an adhesive group, a crosslinkable group or a developable group. Such a functional group may, for example, be OR⁷ (R⁷ is a hydrogen atom, an alkyl group having at most 20 carbon atoms, which may have an etheric oxygen atom, an alkoxycarbonyl group having at most 15 carbon atoms, or CH₂R⁸ wherein R⁸ is an alkoxycarbonyl group having at most 15 carbon atoms), COOR⁹ (R⁹ is a hydrogen atom or an alkyl group having at most 5 carbon atoms), a sulfonic group, an amino group, an epoxy group, a trialkoxysilyl group or a cyano group. Specific examples of R⁷ may, for example, be the same as those of the above R¹. Such a functional group is preferably OR⁷ or COOR⁹, and in such a case, the substitutional rate of the functional group in the fluorinated polymer (A1) (the proportion of the total of OR¹ in the formula (1) and OR⁷ or COOR⁹ wherein each of R¹, R⁷ and R⁹ is other than a hydrogen atom against the total of OR¹ and OR⁷ or COOR⁹) is preferably from 0 to 95 mol%, more preferably from 5 to 75 mol%, particularly preferably from 10 to 60%.

The organic group having a functional group-containing side chain may, for example, be a monovalent organic group such as a functional group-containing alkyl group, a functional group-containing fluoroalkyl group, a functional group-containing alkoxy group or a functional group-containing fluoroalkoxy group. The part where the functional groups are excluded from the organic group having a functional group-containing side chain preferably has at most 8 carbon atoms, particularly preferably has at most 6 carbon atoms.

The following compounds may be mentioned as specific examples of the fluorinated diene (2) in the present invention, but the diene is not limited thereto.

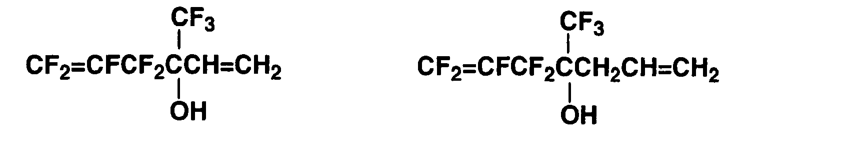

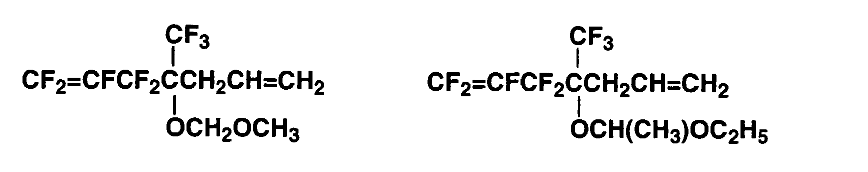

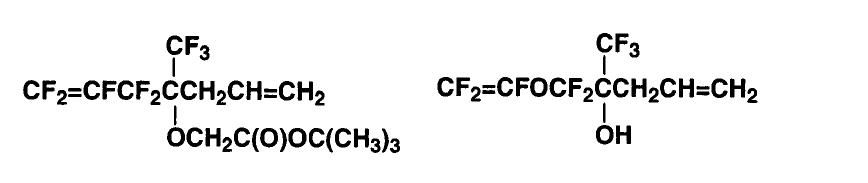

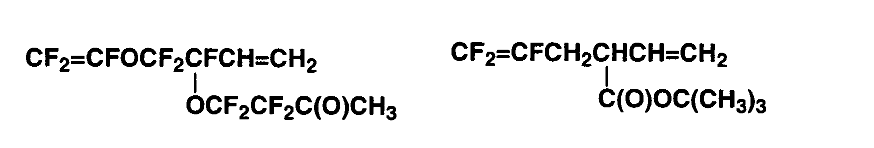

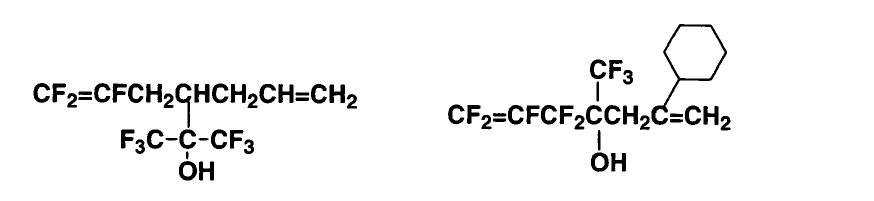

The acrylic monomer (3) in the present invention is a compound represented by the following formula (3):

CH₂=CR⁵COOR⁶ (3)

wherein R⁵ is a hydrogen atom, a fluorine atom, an alkyl group having at most 3 carbon atoms, or a fluoroalkyl group having at most 3 carbon atoms, and especially, from the viewpoint of availability, it is preferably a hydrogen atom, a fluorine atom, a methyl group or a trifluoromethyl group. R⁶ is an alkyl group having at most 20 carbon atoms, and some of hydrogen atoms of the alkyl group may be substituted by fluorine atoms, alkyl groups or fluoroalkyl groups. The alkyl group having at most 20 carbon atoms may, for example, be an alkyl group, a cycloalkyl group, an alkoxymethyl group, a cyclic ether group or a cyclic ester group, which may be substituted by an aryl group or a cycloalkyl group. Here, as such a cycloalkyl group, not only a monocyclic cycloalkyl group such as a cyclohexyl group, but also a polycyclic cycloalkyl group such as a cross-linked polycycloalkyl group such as an adamantyl group or a connected polycycloalkyl group such as a bicyclohexyl group may, for example, be mentioned. Further, the alkyl group moiety of an alkoxy group in e.g. the above alkoxymethyl group may be such a cycloalkyl group as described above. Further, the above alkyl group may have an etheric oxygen atom between carbon atoms (here, an alkoxymethyl group is one of them). Further, in the above aryl group or the cycloalkyl group, a substituent such as an alkyl group, a hydroxyl group or an alkoxy group maybe present.

In the case where R⁶ has no cyclic structure as described above, it is particularly preferred that R⁶ is an alkyl group having at most 6 carbon atoms or a fluoroalkyl group having at most 6 carbon atoms. As the acrylic monomer (3), it is particularly preferred that R⁵ is a hydrogen atom, a fluorine atom, a methyl group or a trifluoromethyl group and R⁶ is an alkyl group having at most 6 carbon atoms or a fluoroalkyl group having at most 6 carbon atoms.

The following acrylates may be mentioned as specific examples of the acrylic monomer (3):
CH₂ =CH-CO₂ CH (CF₃) (CH₃),
CH₂ =CH-CO₂ CH(CF₃)₂,
CH₂=CH-CO₂C(CF₃)(CH₃)₂ ,
CH₂ =CH-CO₂ C(CF₃)₂ (CH₃) ,
CH₂ =CH-CO₂ C(CF₃)₃ ,
CH₂ =CF-CO₂CH(CH₃)₂ ,
CH₂ =CF-CO₂ CH (CF₃) (CH₃) ,
CH₂ =CF-CO₂ CH (CF₃)₂,
CH₂=CF-CO₂C(CH₃)₃ ,
CH₂ =CF-CO₂ C(CF₃) (CH₃)₂ ,
CH₂ = CF-CO₂ C(CF₃) ₂ (CH₃) ,
CH₂ = CF-CO₂ C(CF₃)₃ ,
CH₂ =C(CH₃)-CO₂ CH (CF₃) (CH₃),
CH₂ = C(CH₃)-CO₂ CH (CF₃)₂ ,
CH₂ = C(CH₃)-CO₂ C(CF₃) (CH₃)₂ ,
CH₂ =C(CH₃) -CO₂ C(CF₃)₂ (CH₃) ,
CH₂ =C(CH₃ )-CO₂C(CF₃)₃ ,
CH₂ =C(CF₃) -CO₂ CH (CH₃)₂ ,
CH₂ =C(CF₃)-CO₂ CH (CF₃) (CH₃) ,
CH₂ =C(CF₃)-CO₂ CH (CF₃)₂ ,
CH₂ =C(CF₃)-CO₂ C(CH₃)₃ ,
CH₂ =C(CF₃)-CO₂ C(CF₃) (CH₃)₂ ,
CH₂ =C(CF₃)-CO₂ C(CF₃)₂ (CH₃) ,
CH₂ =C(CF₃)-CO₂ C(CF₃)₃ ,
CH₂ =CF-CO₂CH₃ ,
CH₂ =C(CF₃)-CO₂CH₃ ,
CH₂ =C(CH₃)-CO₂CH₂CH(CH₃)CH₂CH₂CH₂CH₃,
CH₂ =C(CH₃)-CO₂CH₂ (CH(CH₃))₃H.

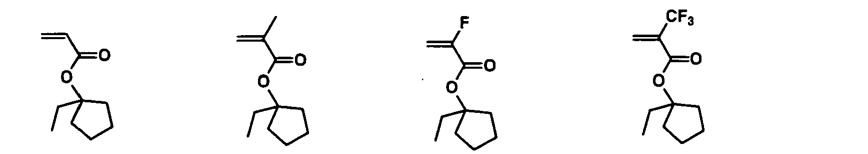

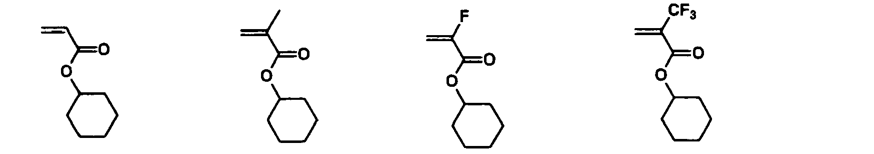

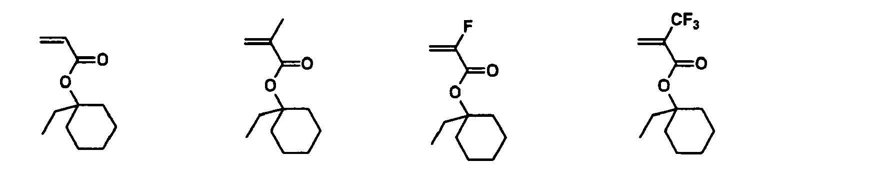

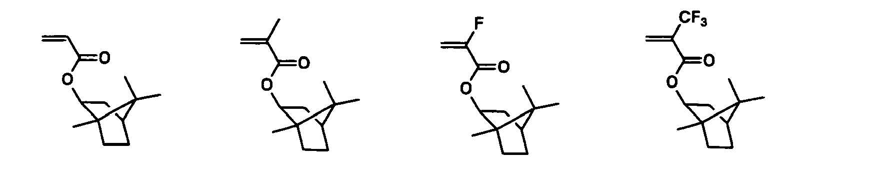

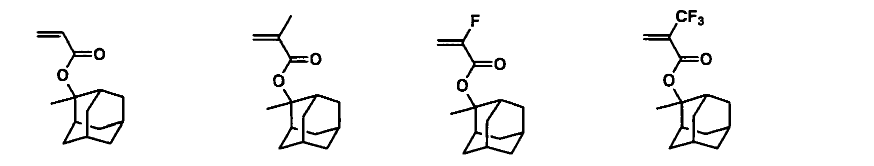

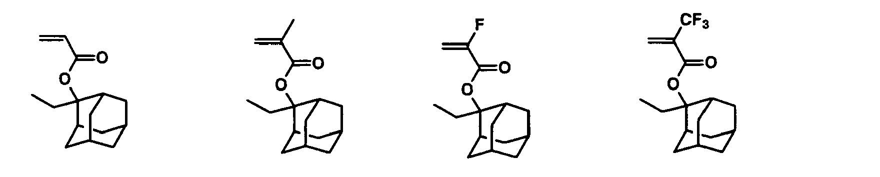

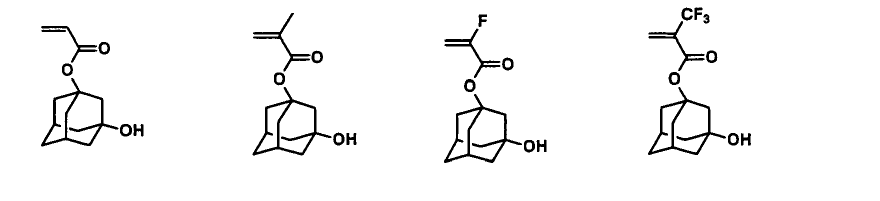

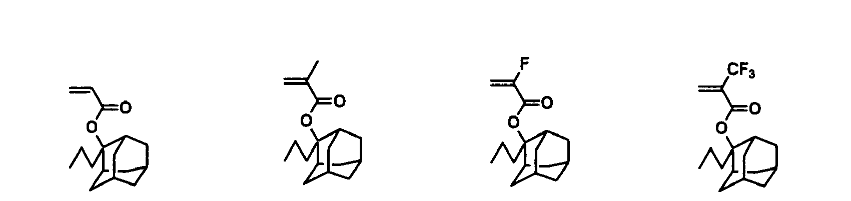

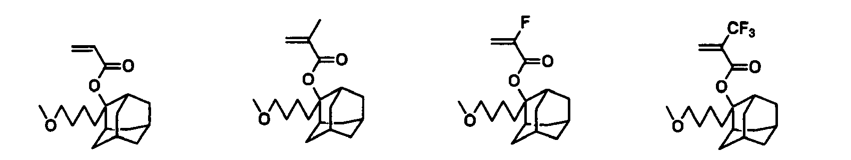

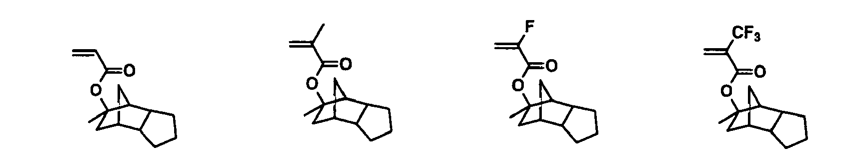

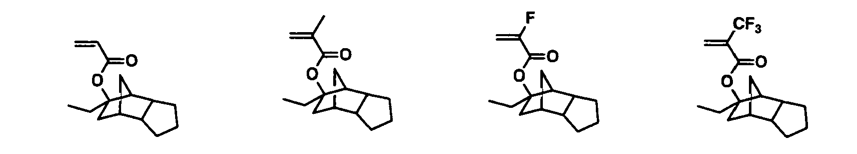

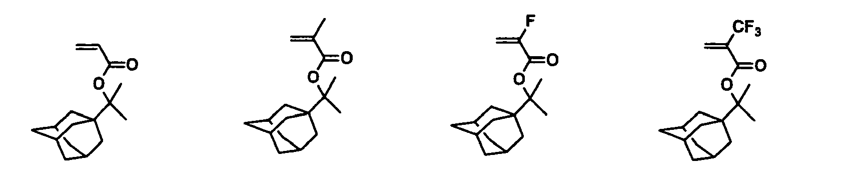

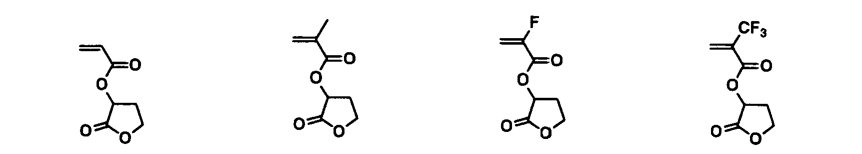

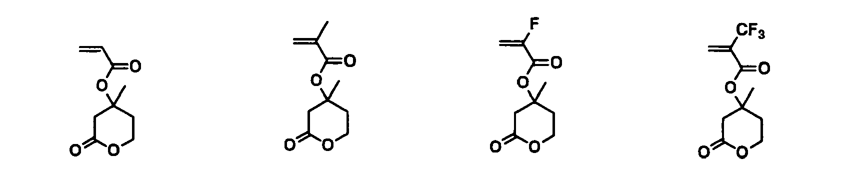

The acrylic monomer (3) can be obtained by bonding CH₂=CHR⁵COOH and R⁶OH by esterification, and therefore acrylic monomers (3) having various structures can readily be prepared.

In the fluorinated copolymer (A2), the substitutional rate of the functional groups (the proportion of the total of OR¹ in the formula (1) and COOR⁶ in the formula (3) wherein each of R¹ and R⁶ is other than a hydrogen atom against the total of OR¹ and COOR⁶) is preferably from 0 to 95 mol%, more preferably from 5 to 75 mol%, particularly preferably from 10 to 60%.

Now, in the present invention, a unit derived from a monomer unit formed by cyclopolymerization of a fluorinated diene (1) is referred to as a monomer unit (1). The same applies to the fluorinated diene (2) and the acrylic monomer (3).

In the fluorinated copolymer (A1) of the present invention, the ratio of monomer unit (1)/monomer unit (2) is preferably 10 to 90 mol%/90 to 10 mol%. Monomer unit (1)/monomer unit (2) is particularly preferably 50 to 90 mol%/50 to 10 mol%. Also in the fluorinated polymer (A2) of the present invention, the ratio of monomer unit (1)/monomer unit (3) is similarly preferably 10 to 90 mol%/90 to 10 mol%. The ratio of monomer unit (1)/monomer unit (3) is preferably 50 to 90 mol%/50 to 10 mol%.

The fluorinated copolymer (A1) contains the monomer unit (1) and the monomer unit (2) as essential components, but may further contain monomer units derived from other radical polymerizable monomers (hereinafter referred to as other monomers) within a range not to impair its characteristics. The proportion of such other monomer units is preferably at most 50 mol%, particularly preferably at most 15 mol%. The same applies to the fluorinated copolymer (A2). Needless to say, they may contain all of the monomer unit (1), the monomer unit (2) and the monomer unit (3).

Such other monomers may, for example, be an α-olefin such as ethylene, propylene or isobutylene, a fluorinated olefin such as tetrafluoroethylene or hexafluoropropylene, a fluorinated vinyl ether such as perfluoropropyl vinyl ether, a fluorinated cyclic monomer such as perfluoro(2,2-dimethyl-1,3-dioxol), a cyclopolymerizable perfluorodiene or hydrofluorodiene, such as perfluoro(butenyl vinyl ether), an alkyl(meth) acrylate such as methyl acrylate or ethyl methacrylate, a vinyl ester such as vinyl acetate, vinyl benzoate or vinyl adamantate, a vinyl ether such as ethyl vinyl ether or cyclohexyl vinyl ether, a cyclic olefin such as cyclohexene, norbornene or norbornadiene, maleic anhydride, or vinyl chloride.

The fluorinated copolymer (A1) or the fluorinated copolymer (A2) of the present invention can be obtained by copolymerizing the fluorinated diene (1), and the fluorinated diene (2) or the acrylic monomer (3), and other monomers as the case requires, in the presence of a polymerization initiating source. The polymerization initiating source is not particularly limited so long as it is capable of letting the polymerization reaction proceed radically, and it may, for example, be a radical-generating agent, light or ionizing radiation. A radical-generating agent is particularly preferred, and it may, for example, be a peroxide, an azo compound or a persulfate. Specific examples of the radical-generating agent include azobisisobutyronitrile, benzoyl peroxide, diisopropyl peroxydicarbonate, di-t-butyl peroxydicarbonate, t-butyl peroxypivalate, perfluorobutyryl peroxide and perfluorobenzoyl peroxide.

The polymerization method is also not particularly limited, and it may, for example, be so-called bulk polymerization wherein a monomer is subjected to polymerization as it is, solution polymerization which is carried out in a fluorohydrocarbon, a chlorohydrocarbon, a fluorochlorohydrocarbon, an alcohol, a hydrocarbon or other organic solvent, which is capable of dissolving the monomers, suspension polymerization which is carried out in an aqueous medium in the absence or presence of a suitable organic solvent, or emulsion polymerization which is carried out in an aqueous medium in the presence of an emulsifier.

The polymerization temperature and pressure are also not particularly limited, but it is preferred to properly set them taking into consideration various factors such as the boiling point of the monomers, the prescribed heating source, removal of the polymerization heat, etc. For example, suitable temperature setting can be carried out between 0°C and 200°C, and practically suitable temperature setting can be carried out within a range of from room temperature to 100°C. Further, the polymerization pressure may be a reduced pressure or an elevated pressure, and practically, the polymerization can properly be carried out within a range of from normal pressure to about 100 atom, preferably from normal pressure to about 10 atom.

The molecular weight of the fluorinated copolymer (A1) or (A2) of the present invention is not particularly limited so long as it is uniformly soluble in the organic solvent (C) as described hereinafter and is uniformly applied on a substrate. However, usually the number average molecular weight as calculated as polystyrene is appropriately from 1,000 to 100,000, preferably from 2,000 to 50,000. If such a number average molecular weight is at least 1,000, when such a polymer is used for a resist composition, a better resist pattern can be obtained, the film-remaining rate after development will be sufficient, and the shape stability at the time of heat treatment of pattern will also be good. Further, if such a number average molecular weight is at most 100,000, the coating property of the resist composition will be better, and the sufficient developability can be maintained.

The fluorinated copolymer (A1) of the present invention may have two or more types of monomer units (1) which are different in R¹, and it may likewise have two or more different types of monomer units (2). The same applies to the fluorinated copolymer (A2).

In the fluorinated copolymer (A1) of the present invention, if R¹ in the monomer unit (1) is a hydrogen atom or if the functional group in the monomer unit (2) is a hydroxyl group, the hydrogen atom in the monomer unit (1) or the hydrogen atom of the hydroxyl group in the monomer unit (2) can be converted to an organic group by a known method such as Williamson's synthesis. The same applies to the hydrogen atom in the monomer unit (1) of the fluorinated copolymer (A2). On the other hand, in the fluorinated copolymer (A1) or (A2), if R¹ is a group other than a hydrogen atom, R¹ can be converted to a hydrogen atom by e.g. hydrolysis.

In the case where the hydrogen atom of the hydroxyl group of the monomer unit (1) in the fluorinated copolymer (A1) or (A2) is converted into an organic group, such an organic group after the conversion is preferably the above R¹ which is other than a hydrogen atom. In the case where the functional group in the monomer unit (2) is a hydroxyl group, the organic group obtained after the conversion from the hydroxyl group to the organic group, is preferably e.g. the above OR⁷ (here R⁷ is other than a hydrogen atom). Likewise, OR¹ of the monomer unit (1) in the fluorinated copolymer (A1) or (A2), a functional group in the side chain of the monomer unit (2) and COOR⁶ of the monomer unit (3) can be converted to other groups after forming copolymers, respectively. Such other groups are preferably ones within the ranges of the above groups respectively. Further, "a unit derived from a monomer unit" in the present invention, is meant for a monomer unit as it is, or a unit chemically converted after polymerization by e.g. conversion of a functional group.

By the polymerization of the fluorinated diene (1) in the present invention, the following monomer units (a) to (c) are considered to be formed, and from the results of the spectroscopic analysis, etc., it is considered possible to obtain a polymer having at least one type of monomer units selected from the group consisting of monomer units (a), monomer units (b) and monomer units (c) by the cyclopolymerization of the fluorinated diene (1). Further, the main chain of such a polymer is meant for a carbon chain constituted by carbon atoms which constitute polymerizable unsaturated bonds (in the case of the fluorinated diene (1), the four carbon atoms which constitute polymerizable unsaturated double bonds).

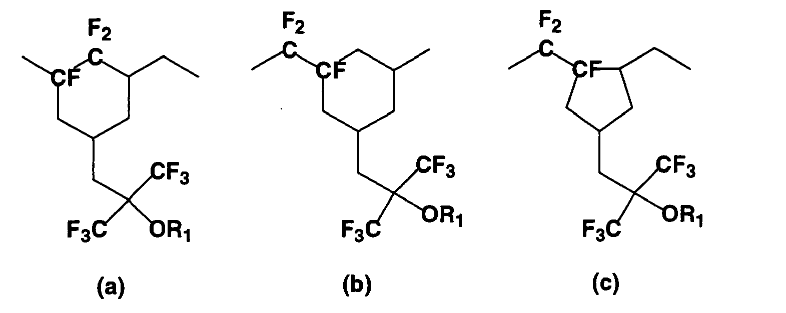

Further, by the cyclopolymerization of the fluorinated diene (2) in the present invention, the following monomer units (d) to (f) are considered to be formed, and from the results of the spectroscopic analysis, etc., it is considered possible to obtain a polymer having a structure comprising at least one type of monomer units selected from the group consisting of monomer units (d), monomer units (e) and monomer units (f) by the cyclopolymerization of the fluorinated diene (2). Further, the main chain of such a polymer is meant for a carbon chain constituted by carbon atoms which constitute polymerizable unsaturated bonds (in the case of the fluorinated diene (2), the four carbon atoms which constitute polymerizable unsaturated double bonds).

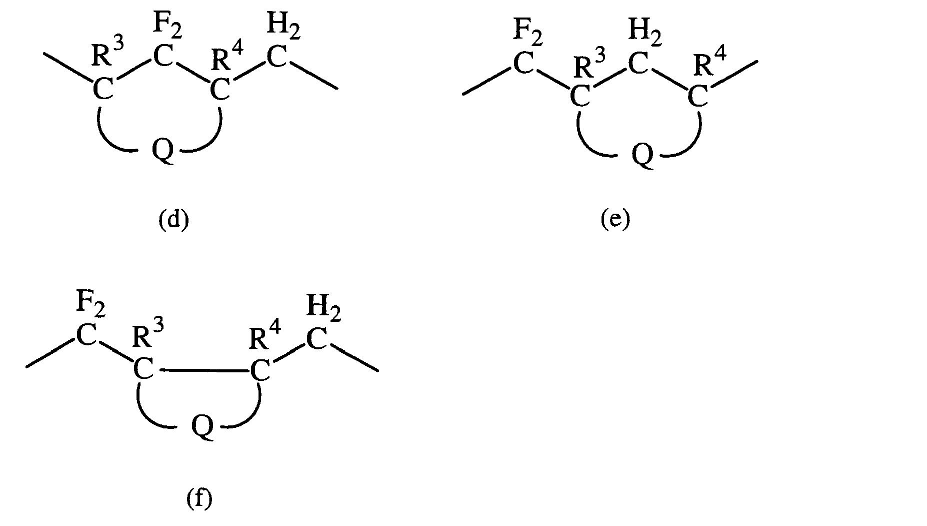

The present invention also provides a resist composition characterized by comprising a fluorinated copolymer (A1) or a fluorinated copolymer (A2) (hereinafter, the fluorinated copolymer (A1) and the fluorinated copolymer (A2) are also collectively referred to as fluorinated copolymers), an acid-generating compound (B) which generates an acid when irradiated with light, and an organic solvent (C).

The acid-generating compound (B) which generates an acid under irradiation with light of the present invention generates an acid under irradiation with light. By the acid thus generated, a blocked acidic group which exists in the fluorinated copolymer, is cleaved (deblocked). As a result, the exposed portions of the resist film will become readily soluble by an alkali developer, whereby a positive resist pattern will be formed by the alkali developer. As such an acid-generating compound (B) which generates an acid under irradiation with light, it is possible to employ an acid-generating compound which is commonly used for a chemical amplification type resist material. Namely, an onium salt, a halogenated compound, a diazoketone compound, a sulfone compound or a sulfonic acid compound may, for example, be mentioned. The following compounds may be mentioned as examples of such an acid-generating compound (B).

The onium salt may, for example, be an iodonium salt, a sulfonium salt, a phosphonium salt, a diazonium salt or a pyridinium salt. Specific examples of a preferred onium salt include diphenyliodonium triflate, diphenyliodoniumpyrene sulfonate, diphenyliodoniumdodecylbenzene sulfonate, bis(4-tert-butylphenyl)iodonium triflate, bis(4-tert-butylphenyl)iodonium dodecylbenzene sulfonate, triphenylsulfonium triflate, triphenylsulfonium nonanate, triphenylsulfoniumperfluorooctane sulfonate, triphenylsulfonium hexafluoroantimonate, 1-(naphthylacetomethyl)thiolanium triflate, cyclohexylmethyl(2-oxocyclohexyl)sulfonium triflate, dicyclohexyl(2-oxocyclohexyl)sulfonium triflate, dimethyl(4-hydroxynaphthyl)sulfonium tosylate, dimethyl(4-hydroxynaphthyl)sulfonium dodecylbenzene sulfonate, dimethyl(4-hydroxynaphthyl)sulfonium naphthalene sulfonate, triphenylsulfonium camphor sulfonate or (4-hydroxyphenyl)benzylmethylsulfonium toluene sulfonate.

The halogenated compound may, for example, be a haloalkyl group-containing hydrocarbon compound or a haloalkyl group-containing heterocyclic compound. Specifically, it may, for example, be a (trichloromethyl)-s-triazine derivative such as phenyl-bis(trichloromethyl)-s-triazine, methoxyphenyl-bis(trichloromethyl)-s-triazine or naphthyl-bis(trichloromethyl)-s-triazine, or 1,1-bis(4-chlorophenyl)-2,2,2-trichloroethane.

The sulfone compound may, for example, be β-ketosulfone, β-sulfonylsulfone or an α-diazo compound of such a compound. Specifically, it may, for example, be 4-trisphenacylsulfone, mesitylphenacylsulfone or bis(phenylsulfonyl)methane. The sulfonic acid compound may, for example, be an alkylsulfonic acid ester, an alkylsulfonic acid imide, a haloalkylsulfonic acid ester, an arylsulfonic acid ester or an iminosulfonate. Specifically, it may, for example, be benzoine tosylate or 1,8-naphthalene dicarboxylic acid imide triflate. In the present invention, such acid-generating compounds (B) may be used alone or in combination as a mixture of two or more of them.

The organic solvent (C) of the present invention is not particularly limited so long as it is capable of dissolving both components of a fluorinated copolymer and an acid-generating compound (B). It may, for example, be an alcohol such as methyl alcohol or ethyl alcohol, a ketone such as acetone, methylisobutyl ketone or cyclohexanone, an acetate such as ethyl acetate or butyl acetate, an aromatic hydrocarbon such as toluene or xylene, a glycol monoalkyl ether such as propylene glycol monomethyl ether or propylene glycol monoethyl ether, or a glycol monoalkyl ether ester such as propylene glycol monomethyl ether acetate or carbitol acetate.

The proportions of the respective components in the resist composition of the present invention are usually such that the acid-generating compound (B) is from 0.1 to 20 parts by mass and the organic solvent (C) is from 50 to 2,000 parts by mass, per 100 parts by mass of the fluorinated copolymer. Preferably, the acid-generating compound (B) is from 0.1 to 10 parts by mass and the organic solvent (C) is from 100 to 1,000 parts by mass, per 100 parts by mass of the fluorinated copolymer.

If the amount of the acid-generating compound (B) is at least 0.1 part by mass, a sufficient sensitivity and developability can be provided, and if it is at most 10 parts by mass, a sufficient transparency to radiation is retained, whereby a more accurate resist pattern can be obtained.

In the resist composition of the present invention, an acid-cleavable additive to improve the pattern contrast, a surfactant to improve the coating property, a nitrogen-containing basic compound to adjust the acid-generating pattern, an adhesion-assisting agent to improve the adhesion to a substrate or a storage stabilizer to enhance the storage stability of the composition, may be optionally incorporated. Further, the resist composition of the present invention is preferably employed in such a manner that the respective components are uniformly mixed, followed by filtration by means of a filter of from 0.1 to 2 µm.

The resist composition of the present invention is applied on a substrate such as a silicon wafer, followed by drying to form a resist film. As the coating method, spin coating, cast coating or roll coating may, for example, be employed. The formed resist film will be irradiated with light through a mask having a pattern drawn thereon, followed by development treatment to form the pattern.

The light beams for the irradiation may, for example, be ultraviolet rays such as g-line having a wavelength of 436 nm or i-line having a wavelength of 365 nm, or far ultraviolet rays or vacuum ultraviolet rays, such as KrF excimer laser having a wavelength of 248 nm, ArF excimer laser having a wavelength of 193 nm or F₂ excimer laser having a wavelength of 157 nm. The resist composition of the present invention is a resist composition which is useful particularly for an application where ultraviolet rays having a wavelength of at most 250 nm, especially ultraviolet rays having a wavelength of at most 200 nm (such as ArF excimer laser or F₂ excimer laser), are used as the light source. In addition, it is such a resist composition that is useful also to an exposure using a so-called immersion technique for improvement of the resolution by utilizing the large refractive index of e.g. water, an organic compound containing fluorine atoms, etc.

As the development treatment solution, various alkali aqueous solutions are employed. As such an alkali material, sodium hydroxide, potassium hydroxide, ammonium hydroxide, tetramethylammonium hydroxide or triethylamine may, for example, be mentioned.

### EXAMPLES

Now, the present invention will be described in detail with reference to Examples, but it should be understood that the present invention is by no means restricted thereto.

Abbreviations used in the following Examples are as follows.
THF: tetrahydrofuran, AIBN: azobisisobutyronitrile, BPO: benzoyl peroxide, PSt: polystyrene, R225: dichloropentafluoropropane (solvent), IPP: diisopropylperoxydicarbonate, PFB: perfluorobutyryl peroxide and PFBPO: perfluorobenzoyl peroxide.

### PREPARATION EXAMPLE 1

### PREPARATION OF CF₂=CFCH₂CH(CH₂C(CF₃)₂OH)CH₂CH=CH₂

Into a 200 mL glass reactor, 118 g of CF₂ClCFClI and 1.1 g of AIBN were put and heated to 75°C. 75.8 g of CH₂=CHCH₂C(CF₃)₂OCH₂OCH₃ was dropwise added thereto over a period of 1 hour. After completion of the dropwise addition, the mixture was stirred at 75°C for 7 hours, and distilled under reduced pressure to obtain 144 g of CF₂ClCFClCH₂CHI(CH₂C(CF₃)₂OCH₂OCH₃) (80-85°C/0 . 16 kPa) .

Into a 2 L glass reactor, 144 g of the above prepared CF₂ClCFClCH₂CHI(CH₂C(CF₃)₂OCH₂OCH₃) and 550 mL of dehydrated THF were put and cooled to -75°C. 220 mL of a 2M-THF solution of CH₂=CHCH₂MgCl was dropwise added thereto over a period of 2 hours.

After stirring at -75°C for 3 hours, 400 mL of an aqueous saturated ammonium chloride solution was added thereto, and the temperature was raised to room temperature. The reaction solution was subjected to liquid separation, and the organic layer was concentrated by an evaporator and then distilled under reduced pressure to obtain 66.3 g of CF₂ClCFClCH₂CH(CH₂C(CF₃)₂OCH₂OCH₃)CH₂CH=CH₂ (54-56°C/0.08 kPa, hereinafter referred to as monomer 2 precursor).

Into a 500 mL glass reactor, 66.3 g of the above prepared CF₂ClCFClCH₂CH(CH₂C(CF₃)₂OCH₂OCH₃)CH₂CH=CH₂ and 200 ml of methanol were put, and a catalytic amount of concentrated hydrochloric acid was added thereto, followed by heating at 60°C for 19 hours. The reaction solution was cooled to room temperature, and 30 mL of water was added to carry out liquid separation. The organic layer was further washed with 150 ml of water to obtain 63 g of a crude liquid. Then, into a 200 mL glass reactor, 30 g of zinc, 78 g of dioxane and 22 g of water were put and heated to 85°C. 63 g of the above crude liquid was dropwise added thereto, and the mixture was stirred for 24 hours. The reaction solution was subjected to filtration and diluted hydrochloric acid was added to carry out liquid separation. The organic layer was washed with a saturated sodium chloride aqueous solution, and then distilled under reduced pressure to obtain 23.6 g of CF₂=CFCH₂CH(CH₂C(CF₃)₂OH)CH₂CH=CH₂ (54-56°C/0.5 kPa, hereinafter referred to as monomer 1).
NMR spectra of monomer 1
¹H-NMR (399.8 MHz, solvent: CDCl₃, standard: tetramethylsilane) δ (ppm): 1.92 (m,2H), 2.33(m,5H), 3.74(br,1H), 5.12(m,2H), 5.75(m,1H).
¹⁹F-NMR (376.2 MHz, solvent: CDCl₃, standard: CFCl₃)δ(ppm): -77.3 (m,3F), -77.8(m,3F), -92.9 (m, 1F), -104.2(dd,J=32.24,85.97 Hz,1F), -123.5(dd,J=85.97,113.9Hz,1F), -171.9(m,1F).

### EXAMPLE 1

6.00 g of monomer 1, 0.35 g of t-butyl methacrylate and 6.36 g of ethyl acetate was charged into a pressure resistant reactor made of glass and having an internal capacity of 30 mL. Then, 0.190 g of PFBPO was added as a polymerization initiator. The interior of the system was freezed-deaerated, and then the reactor was sealed, followed by polymerization for 18 hours in a constant temperature shaking bath (70°C). After the polymerization, the reaction solution was dropped into hexane to reprecipitate the polymer, followed by vacuum drying at 125°C for 10 hours. As a result, 3.56 g of a non-crystalline polymer having a fluorinated cyclic structure in its main chain (hereinafter referred to as polymer 1A), was obtained. The molecular weight measured by GPC employing THF as a solvent and calculated as PSt, was such that the number average molecular weight (Mn) was 10600, and the weight average molecular weight (Mw) was 20600, and Mw/Mn=1.94. Measurement was carried out by the differential scanning calorimetry (DSC), but Tg was not observed within the range of from 40 to 180°C, and the polymer was a white powder at room temperature.

The polymer composition calculated by measurement of ¹⁹F-NMR and ¹H-NMR was such that repeating units made of monomer 1/repeating units made of t-butyl methacrylate=75/25 mol%. The obtained polymer was soluble in acetone, THF, ethyl acetate, methanol and 2-perfluorohexylethanol, and insoluble in R225, perfluoro(2-butyltetrahydrofuran) and perfluoro-n-octane.

### EXAMPLE 2

3.00 g of monomer 1, 1.23 g of 1,1,2,3,3-pentafluoro-4-hydroxy-4-trifluoromethyl-1,6-heptadiene, 1.36 g of 1,1,2,3,3-pentafluoro-4-methoxymethoxy-4-trifluoromethyl-1,6-heptadiene, 0.19 g of dioxane and 8.18 g of ethyl acetate were charged into a pressure resistant reactor made of glass and having an internal capacity of 30 mL. Then, 0.210 g of PFBPO was added as a polymerization initiator. The interior of the system was freezed-deaerated, and then the reactor was sealed, followed by polymerization for 18 hours in a constant temperature shaking bath (70°C). After the polymerization, the reaction solution was dropped into hexane to reprecipitate the polymer, followed by vacuum drying at 125°C for 10 hours. As a result, 5.09 g of a non-crystalline polymer having a fluorinated cyclic structure in its main chain (hereinafter referred to as polymer 2A), was obtained. The molecular weight measured by GPC employing THF as a solvent and calculated as PSt, was such that the number average molecular weight (Mn) was 12300, and the weight average molecular weight (Mw) was 29100, and Mw/Mn=2.37.

Tg measured by the differential scanning calorimetry (DSC) was 114°C, and the polymer was a white powder at room temperature. The polymer composition calculated by measurements of ¹⁹F-NMR and ¹H-NMR such that repeating units made of monomer 1/repeating units made of 1,1,1,3,3,4,5,5-octafluoro-2-propenyl-4-penten-2-ol/1,1,2,3,3-pentafluoro-4-methoxymethoxy-4-trifluoromethyl-1,6-heptadiene=56/22/22 mol%.

The polymer obtained was soluble in acetone, THF, ethyl acetate, methanol and 2-perfluorohexylethanol and was insoluble in R225, perfluoro(2-butyltetrahydrofuran) and perfluoro-n-octane.

### EXAMPLE 3

4.48 g of monomer 1, 0.6 g of 1,1,2-trifluoro-4-t-butoxycarbonyl-1,6-heptadiene and 7.63 g of ethyl acetate were charged into a pressure resistant reactor made of glass and having an internal capacity of 30 mL. Then, 0.191 g of PFBPO was added as a polymerization initiator. The interior of the system was freezed-deaerated, and then the reactor was sealed, followed by polymerization for 18 hours in a constant temperature shaking bath (70°C). After the polymerization, the reaction solution was dropped into hexane to reprecipitate the polymer, followed by vacuum drying at 100°C for 17 hours. As a result, 4.01 g of a non-crystalline polymer having a fluorinated cyclic structure in its main chain (hereinafter referred to as polymer 3A), was obtained. The molecular weight measured by GPC employing THF as a solvent and calculated as PSt, was such that the number average molecular weight (Mn) was 10700, and the weight average molecular weight (Mw) was 20500, and Mw/Mn=1.91.

Tg measured by the differential scanning calorimetry (DSC) was 100°C, and the polymer was a white powder at room temperature. The polymer composition calculated by measurements of ¹⁹F-NMR and ¹H-NMR was such that repeating units made of monomer 1/repeating units made of 1,1,2-trifluoro-4-t-butoxycarbonyl-1,6-heptadiene=81/19 mol%.

The polymer obtained was soluble in acetone, THF, ethyl acetate, methanol and 2-perfluorohexylethanol and was insoluble in perfluoro(2-butyltetrahydrofuran) and perfluoro-n-octane.

### EXAMPLE 4

2.50 g of monomer 1, 0.147 g of t-butyl-2-trifluoromethyl acrylate and 4.17 g of ethyl acetate were charged into a pressure resistant reactor made of glass and having an internal capacity of 30 CC. Then, 6.62 g of R225 solution of PFB (content of PFB: 3 wt%) was added as a polymerization initiator. The interior of the system was freezed-deaerated, and then the reactor was sealed, followed by polymerization for 18 hours in a constant temperature shaking bath (20°C). After the polymerization, the reaction solution was dropped into hexane to reprecipitate the polymer, followed by vacuum drying at 90°C for 23 hours. As a result, 2.37 g of a non-crystalline polymer having a fluorinated cyclic structure in its main chain (hereinafter referred to as polymer 4A), was obtained. The molecular weight measured by GPC employing THF as a solvent and calculated as PSt, was such that the number average molecular weight (Mn) was 17400, and the weight average molecular weight (Mw) was 50600, and Mw/Mn=2.91. Tg measured by the differential scanning calorimetry (DSC) was 105°C, and the polymer was a white powder at room temperature. The polymer composition calculated by measurements of ¹⁹F-NMR and ¹H-NMR was such that repeating units made of monomer 1/repeating units made of t-butyl-2-trifluoromethyl acrylate=91/9 mol%. The polymer obtained was soluble in acetone, THF, ethyl acetate, methanol and 2-perfluorohexylethanol and was insoluble in R225, perfluoro(2-butyltetrahydrofuran) and perfluoro-n-octane.

### EXAMPLE 5

5.00 g of monomer 1, 0.362 g of 3-hydroxy-1-adamantyl methacrylate and 8.45 g of ethyl acetate were charged into a pressure resistant reactor made of glass and having an internal capacity of 30 CC. Then, 0.211 g of PFBPO was added as a polymerization initiator. The interior of the system was freezed-deaerated, and then the reactor was sealed, followed by polymerization for 18 hours in a constant temperature shaking bath (70°C). After the polymerization, the reaction solution was dropped into hexane to reprecipitate the polymer, followed by vacuum drying at 90°C for 20 hours. As a result, 2.67 g of a non-crystalline polymer having a fluorinated cyclic structure in its main chain (hereinafter referred to as polymer 5A), was obtained. The molecular weight measured by GPC employing THF as a solvent and calculated as PSt, was such that the number average molecular weight (Mn) was 11700, and the weight average molecular weight (Mw) was 22500, and Mw/Mn=1.92. Tg measured by the differential scanning calorimetry (DSC) was 130°C, and the polymer was a white powder at room temperature. The polymer composition calculated by measurements of ¹⁹F-NMR and ¹H-NMR was such that repeating units made of monomer 1/repeating units made of 3-hydroxy-1-adamantyl methacrylate=63/37 mol%. The polymer obtained was soluble in acetone, THF, ethyl acetate and 2-perfluorohexylethanol and was insoluble in methanol, R225, perfluoro(2-butyltetrahydrofuran) and perfluoro-n-octane.

### EXAMPLE 6

Into a 300 mL flask, 102.1 g of a monomer 2 precursor, 26 g of zinc and 100.0 g of N-methylpyrrolidinone were put and heated at 75°C for 40 hours. 300 g of water was added to this reaction solution and stirred it, and then filtration under reduced pressure was carried out to remove a residual zinc. Filtrate was subjected to liquid separation to obtain 41.2 g of an organic layer. This organic layer was subjected to simple distillation under reduced pressure to remove low-boiling point components and high-boiling point components readily. As a result, 31.0 g of CF₂=CFCH₂CH(CH₂C(CF₃)₂OCH₂OCH₃)CH₂CH=CH₂ (hereinafter referred to as monomer 2) was obtained.

0.93 g of the monomer 2, 2.33 g of 1,1,2,3,3-pentafluoro-4-hydroxy-4-trifluoromethyl-1,6-heptadiene and 4.44 g of ethyl acetate were charged into a pressure resistant reactor made of glass and having an internal capacity of 30 ml. Then, 0.111 g of PFBPO was added as a polymerization initiator. The interior of the system was freezed-deaerated, and then the reactor was sealed, followed by polymerization for 18 hours in a constant temperature shaking bath (70°C) . After the polymerization, the reaction solution was dropped into hexane to reprecipitate the polymer, followed by vacuum drying at 120°C for 24 hours. As a result, 2.81 g of a non-crystalline polymer having a fluorinated cyclic structure in its main chain, was obtained. The molecular weight measured by GPC employing THF as a solvent and calculated as PSt, was such that the number average molecular weight (Mn) was 15200, and the weight average molecular weight (Mw) was 38000, and Mw/Mn=2.50. Tg measured by the differential scanning calorimetry (DSC) was 113°C, and the polymer was a white powder at room temperature. The polymer composition calculated by measurements of ¹⁹F-NMR and ¹H-NMR was such that repeating unit made of monomer 2/repeating unit made of 1,1,2,3,3-pentafluoro-4- hydroxy -4-trifluoromethyl-1,6-heptadiene=26/74 mol%.

The polymer obtained was soluble in acetone, THF, ethyl acetate, methanol and 2-perfluorohexylethanol and was insoluble in perfluoro(2-butyltetrahydrofuran) and perfluoro-n-octane.

### EXAMPLE 7

4.50 g of monomer 1, 1.36 g of 1,1,2,3,3-pentafluoro-4-methoxymethoxy-4-trifluoromethyl-1,6-heptadiene and 8.79 g of ethyl acetate were charged into a pressure resistant reactor made of glass and having an internal capacity of 30 mL. Then, 0.220 g of PFBPO was added as a polymerization initiator. The interior of the system was freezed-deaerated, and then the reactor was sealed, followed by polymerization for 18 hours in a constant temperature shaking bath (70°C). After the polymerization, the reaction solution was dropped into hexane to reprecipitate the polymer, followed by vacuum drying at 100°C for 10 hours. As a result, a white polymer was obtained.

Such an obtained polymer was dissolved in 50 ml of methanol, separately prepared 2 ml of a methanol solution containing 0.12 g of sodium hydroxide was dropwise added thereto, followed by stirring at room temperature in nitrogen atmosphere overnight. Then, the methanol was removed by an evaporator and 50 ml of THF was added to a residual product, and then 0.4 g of CF₃CH₂OCH₂Cl was dropwise added thereto in a nitrogen atmosphere. As it is, stirring was carried out in a nitrogen atmosphere for 2 days, and as a result, the solution was suspended and colored white by production of sodium chloride. The reaction solution was subjected to filtration through cerite, and concentrated by an evaporator. The concentrated product was dissolved in R225 and washed with water, followed by liquid separation. The R225 layer was dropped into hexane to reprecipitate the polymer, followed by vacuum drying at 100°C for 20 hours. As a result, 5.55 g of a non-crystalline polymer having a fluorinated cyclic structure in its main chain was obtained. The molecular weight measured by GPC employing THF as a solvent and calculated as PSt, was such that the number average molecular weight (Mn) was 12500, and the weight average molecular weight (Mw) was 29400, and Mw/Mn=2.35. Tg measured by the differential scanning calorimetry (DSC) was 105°C, and the polymer was a white powder at room temperature. The polymer composition calculated by measurements of ¹⁹F-NMR and ¹H-NMR was such that repeating unit made of monomer 1/repeating unit made of CF₂=CFCH₂CH (CH₂C(CF₃)₂OCH₂OCH₂CF₃)CH₂CH=CH₂/repeating unit made of 1,1,2,3,3-pentafluoro-4-methoxymethoxy-4-trifluoromethyl-1,6-heptadiene=68/10/22 mol%.

The polymer obtained was soluble in acetone, THF, ethyl acetate, methanol and 2-perfluorohexylethanol and was insoluble in perfluoro(2-butyltetrahydrofuran) and perfluoro-n-octane.

### EXAMPLE 8

5.50 g of a non-crystalline polymer having a fluorinated cyclic structure in its main chain was obtained by carrying out the operation in the same manner as in Example 7 except that in Example 7, 0.44 g of chloromethylcyclohexyl ether was used instead of 0.4 g of CF₃CH₂OCH₂Cl. The molecular weight measured by GPC employing THF as a solvent and calculated as PSt, was such that the number average molecular weight (Mn) was 12300, and the weight average molecular weight (Mw) was 30600, and Mw/Mn=2.49. Tg measured by the differential scanning calorimetry (DSC) was 103°C, and the polymer was a white powder at room temperature. The polymer composition calculated by measurements of ¹⁹F-NMR and ¹H-NMR was such that monomer unit made of monomer 1/repeating unit made of CF₂=CFCH₂CH (CH₂C(CF₃)₂OCH₂OC₆H₁₁ )CH₂CH=CH₂/repeating unit made of 1,1,2,3,3-pentafluoro-4-methoxymethoxy-4-trifluoromethyl-1,6-heptadiene=69/9/22 mol%. C₆H₁₁ represents a cyclohexyl group.

The polymer obtained was soluble in acetone, THF, ethyl acetate, methanol and 2-perfluorohexylethanol and was insoluble in perfluoro(2-butyltetrahydrofuran) and perfluoro-n-octane.

### EXAMPLE 9 to 13

1 g of each of polymers 1A, 2A, 3A, 4A and 5A prepared in Examples 1 to 5 and 0.05 g of trimethylsulfonium triflate were dissolved in 10 g of propylene glycol monomethyl ether acetate and filtered through a filter made of PTFE and filter having a pore diameter of 0.2 µm to produce a resist composition.

The above resist composition was spin-coated on a silicon substrate treated with hexamethyldisilazane, followed by heat treatment at 80°C for 2 minutes to form a resist film having a thickness of 0.3 µm. In an exposure test apparatus flushed with nitrogen, the substrate having the above resist film formed, was placed, and a mask having a pattern drawn by chrome on a quartz plate, was put thereon in close contact therewith. KrF excimer laser beams were irradiated through the mask, whereupon, after exposure at 100°C for 2 minutes, baking was carried out. The development was carried out at 23°C for 1 minute with a tetramethyl ammonium hydroxide aqueous solution (2.38 mass%), followed by washing with pure water for 1 minute. The light transmittance of the resist film and the development test results are shown in Table 1.

**TABLE 1**

| | polymer | Transmittance of light of 157 nm (%) | Line and space width (1/1) (µm) |
|---|---|---|---|
| EXAMPLE 9 | 1A | 53 | 0.16 |
| EXAMPLE 10 | 2A | 48 | 0.16 |
| EXAMPLE 11 | 3A | 50 | 0.16 |
| EXAMPLE 12 | 4A | 47 | 0.16 |
| EXAMPLE 13 | 5A | 21 | 0.17 |

### INDUSTRIAL APPLICABILITY

The fluorinated copolymer of the present invention is applicable to ion exchange resins, ion exchange membranes, fuel cells, various cell materials, optical fibers, electronic members, transparent film materials, agricultural polyvinyl chloride films, adhesives, fiber materials, weather-resistant coating materials or the like, in addition to the use for photoresists.

## Claims

1. A fluorinated copolymer (A1) having units derived from a monomer unit formed by cyclopolymerization of a fluorinated diene represented by the following formula
(1) and units derived from a monomer unit formed by cyclopolymerization of a functional group-containing fluorinated diene represented by the following formula
(2) (provided that the fluorinated diene represented by the formula (1) is excluded):
CF₂=CFCH₂CH (CH₂C (CF₃)₂(OR¹)) CH₂CH=CH₂ (1)
wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms;
CF₂=CR³-Q-CR⁴=CH₂ (2)
wherein each of R³ and R⁴ which are independent of each other, is a hydrogen atom, a fluorine atom, an alkyl group having at most 3 carbon atoms, a fluoroalkyl group having at most 3 carbon atoms, or a cyclic aliphatic hydrocarbon group, and Q is an alkylene group, an oxyalkylene group, a fluoroalkylene group or an oxyfluoroalkylene group, having a functional group or a functional group-containing side chain group.

2. A fluorinated copolymer (A2) having units derived from a monomer unit formed by cyclopolymerization of a fluorinated diene represented by the following formula (1) and units derived from a monomer unit formed by polymerization of an acrylic monomer represented by the following formula (3):
CF₂=CFCH₂CH(CH₂C(CF3)₂(OR¹)) CH₂CH=CH₂ (1)
wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms;
CH₂=CR⁵COOR⁶ (3)
wherein R⁵ is a hydrogen atom, a fluorine atom, an alkyl group having at most 3 carbon atoms, or a fluoroalkyl group having at most 3 carbon atoms, R⁶ is an alkyl group having at most 20 carbon atoms, and some of hydrogen atoms of the alkyl group may be substituted by fluorine atoms, alkyl groups or fluoroalkyl groups.

3. A method for producing a fluorinated copolymer (A1) **characterized by** radical copolymerizing a fluorinated diene represented by the following formula (1) and a functional group-containing fluorinated diene represented by the following formula (2) (provided that a fluorinated diene represented by the formula (1) is excluded):
CF₂=CFCH₂CH (CH₂C (CF₃)₂ (OR¹)) CH₂CH=CH₂ (1)
wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms;
CF₂=CR³-Q-CR⁴=CH₂ (2)
wherein each of R³ and R⁴ which are independent of each other, is a hydrogen atom, a fluorine atom, an alkyl group having at most 3 carbon atoms, a fluoroalkyl group having at most 3 carbon atoms, or a cyclic aliphatic hydrocarbon group, and Q is an alkylene group, an oxyalkylene group, a fluoroalkylene group or an oxyfluoroalkylene group, having a functional group or a functional group-containing side chain group.

4. A method for producing a fluorinated copolymer (A2) having a cyclic structure in its main chain, **characterized by** radical copolymerizing a fluorinated diene represented by the following formula (1) and an acrylic monomer represented by the following formula (3):
CF₂=CFCH₂CH(CH₂C(CF₃)₂(OR¹)) CH₂CH=CH₂ (1)
wherein R¹ is a hydrogen atom, an alkyl group having at most 20 carbon atoms, which may have an etheric oxygen atom, an alkoxycarbonyl group having at most 15 carbon atoms, or CH₂R² (wherein R² is an alkoxycarbonyl group having at most 15 carbon atoms), and the alkyl group and the alkoxycarbonyl group for R¹, and R² may have some or all of their hydrogen atoms substituted by fluorine atoms;
CH₂=CR⁵COOR⁶ (3)
wherein R⁵ is a hydrogen atom, a fluorine atom, an alkyl group having at most 3 carbon atoms, or a fluoroalkyl group having at most 3 carbon atoms, R⁶ is an alkyl group having at most 20 carbon atoms, and some of hydrogen atoms of the alkyl group may be substituted by fluorine atoms, alkyl groups or fluoroalkyl groups.

5. A resist composition **characterized by** comprising a fluorinated copolymer (A1) as defined in Claim 1, an acid-generating compound (B) which generates an acid when irradiated with light, and an organic solvent (C).

6. A resist composition **characterized by** comprising a fluorinated copolymer (A2) as defined in Claim 2, an acid-generating compound (B) which generates an acid when irradiated with light, and an organic solvent (C).
